# EUROPEAN PATENT APPLICATION

(11) **EP 1 189 275 A1**
(43) Date of publication of application: **20.03.2002**
(21) Application number: 01915813.8
(22) Date of filing: 26.03.2001
(51) Int. Cl.: H01L 21/68

(54) **SUBSTRATE TRANSFER DEVICE**

(30) Priority: 29.03.2000 JP 2000009144
(71) Applicant: Daikin Industries, Ltd., Osaka-shi, Osaka 530-8323 (JP)
(72) Inventor: WADA, Sadayuki, Daikin Industries Ltd., Sakai-shi, Osaka 592-8331 (JP)
(74) Representative: Herrmann-Trentepohl, Werner, Dipl.-Ing.
(86) International application number: JP0102450
(87) International publication number: WO0173840

(57) **Abstract**

In this substrate transport apparatus, portions connecting a transport chamber (101) with a first load-lock chamber (109) and a second load-lock chamber (110) are provided to linearly align with each other. A processing station (120,121) for processing a substrate (400) is provided on a position not interfering with rotational motion and telescopic motion of a robot arm (106). A substrate transport apparatus capable of improving the degree of integration of the apparatus while suppressing enlargement of a foot print and implementing common load-lock chambers can be provided by employing this structure.

## Description

### Technical Field

The present invention relates to a substrate transport apparatus, and more particularly, it relates to a substrate transport apparatus capable of improving the degree of integration of the apparatus without enlarging a foot print.

### Background Art

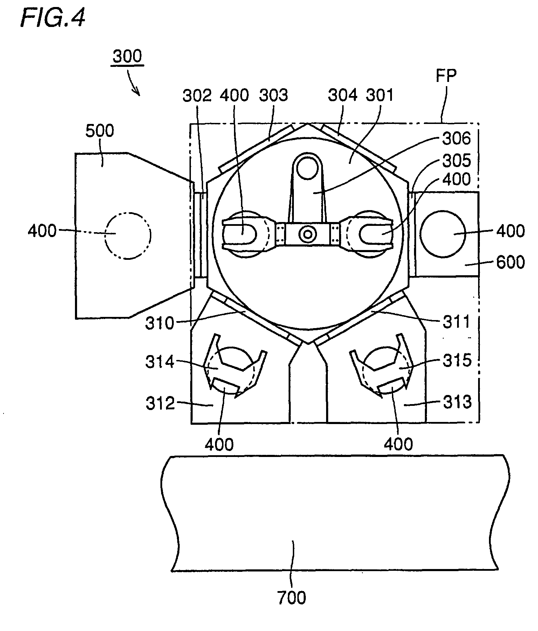

A conventional substrate transport apparatus 300 is schematically described with reference to Fig. 4. This substrate transport apparatus 300 comprises a transport chamber 301 having a robot arm 306 performing rotational motion and telescopic motion for transporting substrates 400 to be processed and rendering a plurality of substrate processing chambers 500 substantially circumferentially arrangeable. The transport chamber 301 has four ports 302, 303, 304 and 305 connectable with the substrate processing chambers 500 or the like.

Load-lock chambers 312 and 313 for placing cassettes 314 and 315 storing the substrates 400 in the wait state to be vertically movable and rotatable are provided on the side for carrying in/out the substrates 400 into/from the transport chamber 301 through gate valves 310 and 311.

In order to provide the load-lock chambers 312 and 313 in the aforementioned substrate transport apparatus 300 for four processing chambers, the transport chamber 301 has a substantially hexagonal shape so that the aforementioned ports 302, 303, 304 and 305 are provided on four sides thereof and the load-lock chambers 312 and 313 are provided on the remaining two sides.

The front sides of the load-lock chambers 312 and 313, generally defining a transportation/working passage, must be linearly provided. Consequently, bent shapes are employed for the load-lock chambers 312 and 313, as shown in Fig. 4.

In the conventional substrate transport apparatus 300, the aforementioned port 305 is provided with a processing station 600 different from the substrate processing chambers 500. This processing station 600 is provided with an aligner for previously aligning the crystal orientations of the substrates 400 introduced into the substrate processing chambers 500, a cooler for cooling the substrates 400 processed in the substrate processing chambers 500 and the like, for example.

While Fig. 4 illustrates only a single substrate processing chamber 500 provided on the port 302 for convenience of illustration, it is assumed that similar substrate processing chambers 500 are provided also on the ports 303 and 304 in practice.

When the processing station 600 is provided on the substrate transport apparatus 300 having the aforementioned structure, however, a foot print FP (the total set area of the apparatus projected from right above the apparatus when the apparatus is set on a plane) shown by two-dot chain lines in Fig. 4 is disadvantageously enlarged. Further, the port 305 is occupied by the processing station 600 provided thereon.

When the number of attachable substrate processing chambers 500 is increased, further, the transport chamber 301 is so increased in size that load-lock chambers suitable to the shape of the transport chamber 301 must be designed and the load-lock chambers cannot be rendered common to another substrate transport apparatus.

### Disclosure of the Invention

Accordingly, an object of the present invention is to provide a substrate transport apparatus capable of improving the degree of integration of the apparatus while suppressing enlargement of a foot print and implementing a common load-lock chamber.

In order to attain the aforementioned object, a substrate transport apparatus according to a first aspect of the present invention comprises a robot arm performing rotational motion and telescopic motion for transporting a substrate, a transport chamber having the aforementioned robot arm and rendering a plurality of substrate processing chambers substantially circumferentially arrangeable, and a first load-lock chamber and a second load-lock chamber for placing the aforementioned substrate transported to the aforementioned substrate processing chamber by the aforementioned robot arm in the wait state or for receiving the aforementioned substrate processed in the aforementioned substrate processing chamber, and junctions between the aforementioned transport chamber and the aforementioned first and second load-lock chambers are provided to linearly align with each other.

According to this structure, the portions connecting the first and second load-lock chambers with the transport chamber linearly align with each other, whereby the aforementioned first and second load-lock chambers can be rendered common to another apparatus regardless of the size of the transport chamber.

According to a second aspect of the present invention, a processing station for processing the aforementioned substrate is provided on the side of the aforementioned transport chamber closer to the aforementioned first and second load-lock chambers on a position not interfering with the rotational motion and the telescopic motion of the robot arm in the substrate transport apparatus according to the first aspect.

According to this structure, the portions connecting the first and second load-lock chambers with the transport chamber linearly align with each other, whereby the aforementioned first and second load-lock chambers can be rendered common to another apparatus regardless of the size of the transport chamber.

Further, the locus of the rotational motion of the robot arm circles and the portions connecting the first and second load-lock chambers with the transport chamber are linear, and hence a space is defined between the locus of the rotational motion of the aforementioned robot arm and the linear portions of the first and second load-lock chambers. The processing station is provided on the position not interfering with the rotational motion and the telescopic motion of the robot arm through this space so that the processing station can be provided without increasing the number of ports for arranging the substrate processing chamber, whereby the degree of integration of the substrate transport apparatus can be improved while suppressing enlargement of a foot print.

According to a third aspect of the present invention, two aligners are provided as the aforementioned processing station in the substrate transport apparatus according to the second aspect. According to this structure, the number of previously aligned substrates can be increased, whereby the throughput (the number of substrates processible in a unit time) in the substrate transport apparatus can be improved.

According to a fourth aspect of the present invention, two coolers are provided as the aforementioned processing station in the substrate transport apparatus according to the second aspect. According to this structure, the number of substrates to be cooled after processing can be increased, whereby the throughput in the substrate transport apparatus can be improved.

According to a fifth aspect of the present invention, an aligner and a cooler are provided as the aforementioned processing station in the substrate transport apparatus according to the second aspect. According to this structure, the number of previously aligned substrates as well as the number of substrates to be cooled after processing can be increased, whereby the throughput in the substrate transport apparatus can be improved.

According to a sixth aspect of the present invention, a base for temporarily receiving the substrate and a base for receiving a dummy substrate are provided as the aforementioned processing station in the substrate transport apparatus according to the second aspect. Thus, the base for temporarily receiving the substrate is so provided that the substrate can be temporarily kept when the substrate cannot be returned to the load-lock chambers for some reason during transportation. Further, the base for receiving the dummy substrate is so provided that processing conditions of the substrate processing chamber can be previously confirmed and the dummy substrate used for cleaning the processing chamber can be temporarily placed thereon, whereby workability can be improved.

A substrate transport apparatus according to a seventh aspect of the present invention comprises a load-lock chamber arranged on a position opposed to a working passage for transporting a substrate, a transport chamber arranged on the side of this load-lock chamber opposite to the passage, a plurality of substrate processing chambers arranged on the outer periphery of this transport chamber and a robot arm arranged in the aforementioned transport chamber for reciprocating between the aforementioned load-lock chamber and the aforementioned substrate processing chamber and introducing/discharging the aforementioned substrate, and the junction surface between the aforementioned load-lock chamber and the aforementioned transport chamber has a linear junction parallel to the aforementioned working passage for coupling the aforementioned load-lock chamber through this junction.

According to this structure, the portion connecting the load-lock chamber with the transport chamber defines a linear junction parallel to the working passage, so that the aforementioned load-lock chamber can be rendered common to another apparatus regardless of the size of the transport chamber.

According to an eighth aspect of the present invention, a processing station for processing the aforementioned substrate is provided on the side of the aforementioned transport chamber retracted from the range of motion of the aforementioned robot arm in the substrate transport apparatus according to the seventh aspect.

According to this structure, the locus of rotational motion of the robot arm circles and the portion connecting the load-lock chamber with the transport chamber is linear, and hence a space is defined between the locus of the rotational motion of the aforementioned robot arm and the linear portion of the load-lock chamber. The processing station is provided on the side of the aforementioned transport chamber retracted from the range of motion of the aforementioned robot arm through this space so that the processing station can be provided without increasing the number of ports for arranging the substrate processing chamber, whereby the degree of integration of the substrate transport apparatus can be improved while suppressing enlargement of a foot print.

### Brief Description of the Drawings

Fig. 1 is a plan view showing the structure of a substrate transport apparatus according to a first embodiment of the present invention.
Fig. 2 is a plan view showing the structure of a substrate transport apparatus according to a second embodiment of the present invention.
Fig. 3 is a plan view showing the structure of a substrate transport apparatus according to still another embodiment of the present invention.
Fig. 4 is a sectional view showing the structure of a substrate transport apparatus according to prior art.

### Best Modes for Carrying Out the Invention

Structures of substrate transport apparatuses according to embodiments of the present invention are now described with reference to the drawings.

### (First Embodiment)

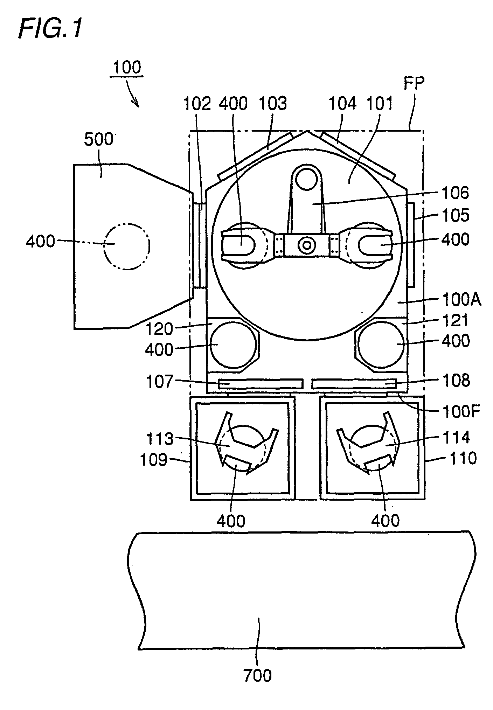

The structure of a substrate transport apparatus 100 according to a first embodiment of the present invention is described with reference to Fig. 1.

### (Structure)

Referring to Fig. 1, this substrate transport apparatus 100 comprises a transport chamber 101 having a robot arm 106 performing rotational motion and telescopic motion and rendering a plurality of substrate processing chambers 500 circumferentially arrangeable, in order to transport substrates 400 to be processed. The transport chamber 101 has four ports 102, 103, 104 and 105 connectable with the substrate processing chambers 500 etc.

Load-lock chambers 109 and 110 for placing cassettes 113 and 114 storing the substrates 400 in the wait state to be vertically movable and rotatable are provided on the side for introducing/discharging the substrates 400 into/from the transport chamber 101 through gate valves 107 and 108.

In the aforementioned substrate transport apparatus 100 for four processing chambers, junctions 100F between the transport chamber 101 and the first and second load-lock chambers 109 and 110 are provided in the form of aligning straight lines, and arranged to be parallel to a working passage 700. According to this structure, the transportation/working passage 700 is generally provided on the front sides of the first load-lock chamber 109 and the second load-lock chamber 110 similarly to the prior art, and hence the front sides of the first load-lock chamber 109 and the second load-lock chamber 110 must be linearly provided. Consequently, substantially square shapes can be employed for the first load-lock chamber 109 and the second load-lock chamber 110 according to this embodiment, as shown in Fig. 1.

In the substrate transport apparatus 100 according to this embodiment, further, processing stations 120 and 121 for processing the substrates 400 are provided on positions not interfering with the rotational motion and the telescopic motion of the robot arm 106 provided in the transport chamber 101 located on the side opposite to the working passage 700. More specifically, the processing stations 120 and 121 may be formed by a combination of an aligner and an aligner, a combination of cooler and a cooler, a combination of an aligner and a cooler or the like.

A base for temporarily receiving the substrates 400 and a base for receiving a dummy substrate can alternatively be provided as the processing stations 120 and 121. The base for temporarily receiving the substrates 400 is so provided that the substrates 400 can be temporarily stored when the same cannot be returned to the load-lock chambers 109 and 110 for some reason during transportation. Further, the base for receiving the dummy substrate is so provided that processing conditions of the substrate processing chambers 500 can be previously confirmed and the dummy substrate used for cleaning the processing chambers 500 can be temporarily kept, whereby workability can be improved.

While Fig. 1 illustrates only a single substrate processing chamber 500 provided on the port 102 for convenience of illustration, it is assumed that substrate processing chambers 500 are provided also on the ports 103, 104 and 105 in practice.

### (Function/Effect)

Thus, the locus of the rotational motion of the robot arm 106 circles and the portions connecting the first and second load-lock chambers 109 and 110 with the transport chamber 101 are linear, whereby a space is defined between the locus of the rotational motion of the robot arm 106 and the linear portions of the first and second load-lock chambers 109 and 110.

The processing stations 120 and 121 are provided on the positions not interfering with the rotational motion and the telescopic motion of the robot arm 106 through this space, whereby the processing stations 120 and 121 can be provided without increasing the number of the ports 102 to 105.

Consequently, the degree of integration of the substrate transport apparatus 100 can be improved while suppressing enlargement of a foot print FP as compared with the conventional apparatus.

Further, the number of previously aligned substrates and the number of substrates to be cooled after processing can be increased by providing an aligner, a cooler and/or the like as the processing stations 120 and 121, whereby the throughput in the substrate transport apparatus 100 can be improved.

### (Second Embodiment)

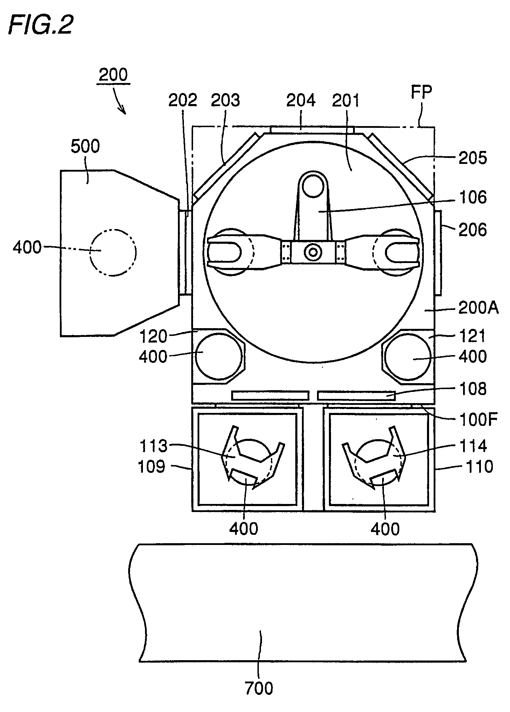

The structure of a substrate transport apparatus 200 according to a second embodiment of the present invention is now described with reference to Fig. 2.

### (Structure)

Referring to Fig. 2, the difference between the substrate transport apparatus 200 according to this embodiment and the aforementioned substrate transport apparatus 100 according to the first embodiment resides in that the substrate transport apparatus 100 is employed for four processing chambers 500 while the substrate transport apparatus 200 is employed for five processing chambers.

Consequently, the substrate transport apparatus 200 has a large-sized transport chamber 201, which is provided with ports 202, 203, 204, 205 and 206. The remaining structure of this substrate transport apparatus 200 is identical to that of the substrate transport apparatus 100.

### (Function/Effect)

The same function/effect as the substrate transport apparatus 100 can be attained due to the aforementioned structure, while portions connecting first and second load-lock chambers 109 and 110 with the transport chamber 201 are linear and hence common first and second load lock chambers 109 and 110 can be employed for the substrate transport apparatuses 100 and 200 regardless of the size of the transport chamber 201.

### (Still Another Embodiment)

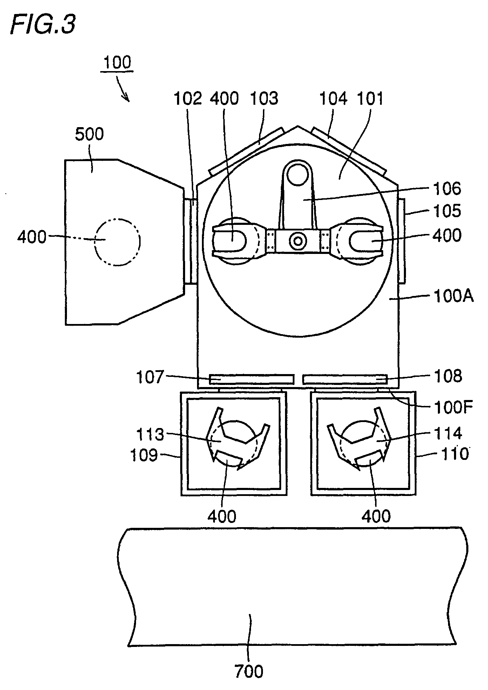

While each of the aforementioned embodiments is provided with the processing stations 120 and 121, a structure provided with no processing stations 120 and 121 can also be employed as shown in Fig. 3.

The substrate transport apparatus in each of the aforementioned embodiments is applicable to an apparatus bringing a transport chamber and load-lock chambers into a vacuum state or an atmospheric pressure state or another apparatus employed under any atmosphere.

Therefore, each embodiment disclosed this time is considered to be illustrative in all points and not restrictive. The technical range of the present invention is defined not by the above description but by the scope of claim for patent, and it is intended that all modifications within the meaning and range equivalent to the scope of claim for patent are included.

In the substrate transport apparatus according to the present invention, as hereinabove described, the portions connecting the first and second load-lock chambers with the transport chamber are linear, whereby the first and second load-lock chambers can be rendered common to another apparatus regardless of the size of the transport chamber. Further, the processing stations are provided on the positions not interfering with the rotational motion and the telescopic motion of the robot arm through the space defined between the locus of the rotational motion of the robot arm and the linear portions of the first and second load-lock chambers so that the processing stations can be provided without increasing the number of the ports for arranging the substrate processing chambers, whereby the degree of integration of the substrate transport apparatus can be improved while suppressing enlargement of the foot print.

### Industrial Applicability

A substrate transport apparatus capable of improving the degree of integration of the apparatus while suppressing enlargement of a foot print and implementing common load-lock chambers is provided.

## Claims

1. A substrate transport apparatus comprising:
a robot arm (106) performing rotational motion and telescopic motion for transporting a substrate (400);
a transport chamber (101, 201) having said robot arm (106) and rendering a plurality of substrate processing chambers (500) substantially circumferentially arrangeable; and
a first load-lock chamber (109) and a second load-lock chamber (110) for placing said substrate (400) transported to said substrate processing chamber (500) by said robot arm (106) in the wait state or for receiving said substrate (400) processed in said substrate processing chamber (500), wherein
junctions (100F) between said transport chamber (101, 201) and said first load-lock chamber (109) and said second load-lock chamber (110) are provided to linearly align with each other.

2. The substrate transport apparatus according to claim 1, wherein a processing station (120, 121) for processing said substrate (400) is provided on the side of said transport chamber (101, 201) closer to said first load-lock chamber (109) and said second load-lock chamber (110) on a position not interfering with said rotational motion and said telescopic motion of said robot arm (106).

3. The substrate transport apparatus according to claim 2, wherein two aligners are provided as said processing station (120, 121).

4. The substrate transport apparatus according to claim 2, wherein two coolers are provided as said processing station (120, 121).

5. The substrate transport apparatus according to claim 2, wherein an aligner and a cooler are provided as said processing station (120, 121).

6. The substrate transport apparatus according to claim 2, wherein a base for temporarily receiving said substrate (400) and a base for receiving a dummy substrate are provided as said processing station (120, 121).

7. A substrate transport apparatus comprising:
a load-lock chamber (109, 110) arranged on a position opposed to a working passage (700) for transporting a substrate (400);
a transport chamber (101) arranged on the side of said load-lock chamber (109, 110) opposite to said passage;
a plurality of substrate processing chambers (500) arranged on the outer periphery of said transport chamber (101); and
a robot arm (106) arranged in said transport chamber (101) for reciprocating between said load-lock chamber (109, 110) and said substrate processing chamber (500) and introducing/discharging said substrate (400), wherein
the junction surface between said load-lock chamber (109, 110) and said transport chamber (101) has a linear junction (100F) parallel to said working passage (700) for coupling said load-lock chamber (109, 110) through said junction (100F).

8. The substrate transport apparatus according to claim 7, wherein a processing station (120, 121) for processing said substrate (400) is provided on the side of said transport chamber (101) retracted from the range of motion of said robot arm (106).
